# EUROPEAN PATENT APPLICATION

(11) **EP 2 426 709 A1**
(43) Date of publication of application: **07.03.2012**
(21) Application number: 10175077.6
(22) Date of filing: 02.09.2010
(51) Int. Cl.: H01L 21/762

(54) **Semiconductor Substrate**

(71) Applicant: NXP B.V., 5656 AE Eindhoven (NL)
(72) Inventor: Golubovic, Dusan, Redhil, Surrey RH1 1D (GB); Boccardi, Guillaume, Redhill, Surrey RH1 1DL (GB)
(74) Representative: Burton, Nick

(57) **Abstract**

A semiconductor substrate includes a layer of semiconductor material. The substrate also includes a series of trenches extending fully through the layer of semiconductor material to define a plurality of device regions therein. The trenches contain a dielectric material. The device regions are electrically isolated from each other by the trenches. A method of making the substrate includes providing an initial layer of semiconductor material. The method also includes forming a series of trenches extending partially through the initial layer to define a plurality of device regions therein. The method further includes providing dielectric material in the trenches. The method also includes removing semiconductor material from an underside of the initial layer to leave a layer of semiconductor material through which the trenches fully extend, whereby the device regions are electrically isolated from each other by the trenches.

## Description

### BACKGROUND OF THE INVENTION

This invention relates to a semiconductor substrate.

It is known to provide devices including analogue devices and low-voltage or high-voltage semiconductor transistors in Silicon-on-Insulator (SOI) substrates. This allows the devices to be electrically isolated from the remainder of the substrate. However, SOI wafers are more expensive to produce than bulk wafers, and can suffer from mechanical stress effects such as bowing and warping. SOI wafers also typically include a larger number of defects than bulk wafers.

Another problem associated with SOI wafers is that the buried oxide (BOX) layer which is typically used therein limits thermal conductivity through the substrate, which in turn can lead to device over-heating problems. Because of this, devices such as relay drivers (drivers with an inductive load) may need to occupy a larger area than is required from their electrical resistance, in order to allow sufficient heat dissipation through the BOX layer.

Accordingly, it is desirable to develop alternative ways to electrically isolate devices in a substrate. In particular, it is desirable to develop a substrate which allows the devices therein to be effectively electrically isolated, while allowing sufficient thermal dissipation to prevent design compromises relating to the devices themselves (e.g. relating to their size, as noted above).

### SUMMARY OF THE INVENTION

Aspects of the invention are set out in the accompanying independent and dependent claims. Combinations of features from the dependent claims may be combined with features of the independent claims as appropriate and not merely as explicitly set out in the claims.

According to an aspect of the invention, there is provided a semiconductor substrate comprising:
a layer of semiconductor material; and
a series of trenches extending fully through the layer of semiconductor material to define a plurality of device regions in said layer, wherein the trenches contain a dielectric material, and wherein the device regions are electrically isolated from each other by said trenches.

According to another aspect of the invention, there is provided a method of making a semiconductor substrate, the method comprising:
providing an initial layer of semiconductor material;
forming a series of trenches extending partially through the initial layer to define a plurality of device regions in the initial layer;
providing dielectric material in the trenches; and
removing semiconductor material from an underside of the initial layer to leave a layer of semiconductor material through which the trenches fully extend, whereby the device regions are electrically isolated from each other by said trenches.

By providing substrates having a semiconductor layer through which a series of trenches fully extend, device regions can be defined which are electrically isolated from each other. Since no BOX layer is strictly necessary, the thermal conductivity of the substrate may be improved with respect to SOI substrates. Moreover, a substrate according to this invention can be manufactured from an initial bulk wafer, and may therefore be cheaper to produce than SOI wafers.

The improved thermal conductivity of a substrate according to an embodiment of this invention makes such substrates particularly suited to devices which require a high degree of electrical isolation and which produce a large amount of heat (e.g. high voltage switching devices).

The device regions can be populated with electronic components such as transistors, diodes and capacitors etc. Metallization and passivation layers can be provided upon an upper surface of the layer of semiconductor material.

The lateral dimensions of the device regions can be chosen in accordance with the kind and quantity of the electronic components which occupy them. In one example, each device region is occupied by a single component or device. By way of example only, a device region occupied by a single high-voltage device may have dimensions of the order of 100-400 square microns. It is, nevertheless, envisaged that much larger device regions can be used, and that each device region may accommodate large numbers of individual components.

In one embodiment, a backing layer can be provided (e.g. using a coating process such as spin-coating) on a lower surface of the layer of semiconductor material. This can mechanically strengthen the substrate, to mitigate against any loss of strength caused by removing semiconductor material from the underside thereof. The backing layer can be an electrically insulating material, and can be chosen to have good thermal properties. For example, a polymer such as polymide can be used.

In one embodiment, the layer of semiconductor material can have a thickness in the range 20 µm < T < 50 µm.

As described in more detail below, the device regions can have a number of different configurations. For example, the device regions can comprise quadrilateral shaped islands.

In one embodiment the trenches can contain a dielectric liner filed with polysilicon. The trenches filed in this way are better able counteract stress effects such as bowing and warping than a trenches filled entirely with dielectric.

A method of making a substrate according to an embodiment of the invention can include removing semiconductor material from an underside of the initial layer using a coarse grinding stage followed by a fine grinding stage. A polishing stage can also be included. These stages allow precise control over the final thickness and underside surface roughness of the semiconductor layer.

### BRIEF DESCRIPTION OF THE DRAWINGS

Embodiments of the present invention will be described hereinafter, by way of example only, with reference to the accompanying drawings in which like reference signs relate to like elements and in which:
Figures 1 to 7 show a method of making a semiconductor substrate in accordance with an embodiment of the invention; and
Figure 8 shows a semiconductor substrate in accordance with an embodiment of the invention.

### DETAILED DESCRIPTION

Embodiments of the present invention are described in the following with reference to the accompanying drawings.

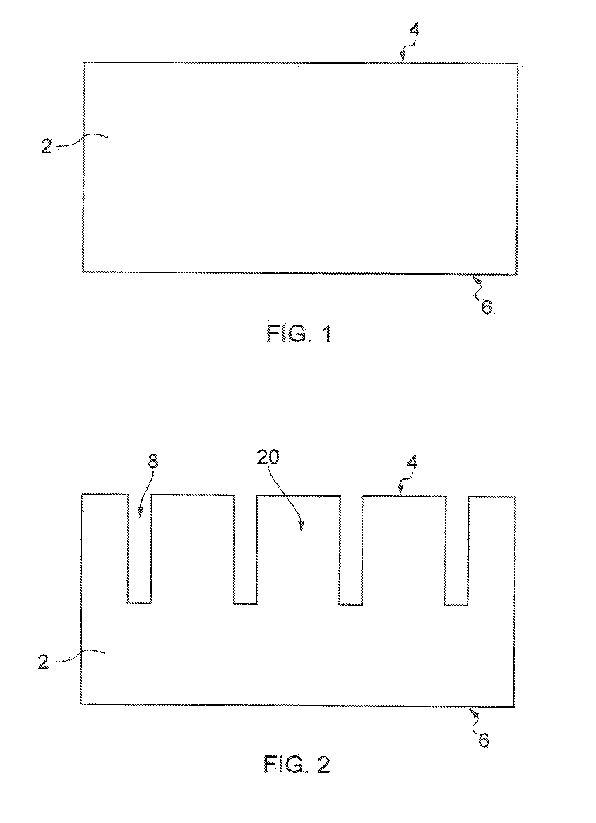

An example method of making a semiconductor substrate in accordance with an embodiment of the invention is described below in relation to Figures 1-7.

As shown in Figure 1, a first stage of making the substrate includes providing an initial layer 2 of semiconductor material. The initial layer 2 may comprise or be a part of a semiconductor wafer. Typically, the initial layer 2 may comprise silicon. The initial layer 2 has two main surfaces, which will be referred to herein after as the major surface 4 and the underside 6.

In Figure 2, it is shown that a next stage in the process comprises forming a series of trenches 8 in the initial layer 2. As can be seen from Figure 2, the trenches 8 extend partially through the initial layer 2. The trenches are formed in the major surface 4. The trenches 8 can be formed using any suitable technique, such as masking and etching processes, which are well known in the art.

The depth to which the trenches 8 extend through the initial layer 2 can be chosen to correspond to the desired depth of the eventual substrate. In accordance with an embodiment of the invention, the substrate which results from the method described herein may have a thickness between 20 and 50 microns. Accordingly, the depth of the trenches 8 provided in the initial layer 2 may lie within the range 20 - 50 microns. In some examples though, it is envisaged that the trenches 8 may be deeper than the eventual thickness of the substrate which is produced. In such examples, the amount of material subsequently removed from the underside 6 of the initial layer 2 as described herein below may include a certain amount of material occupied by the bottom part of the trenches 8.

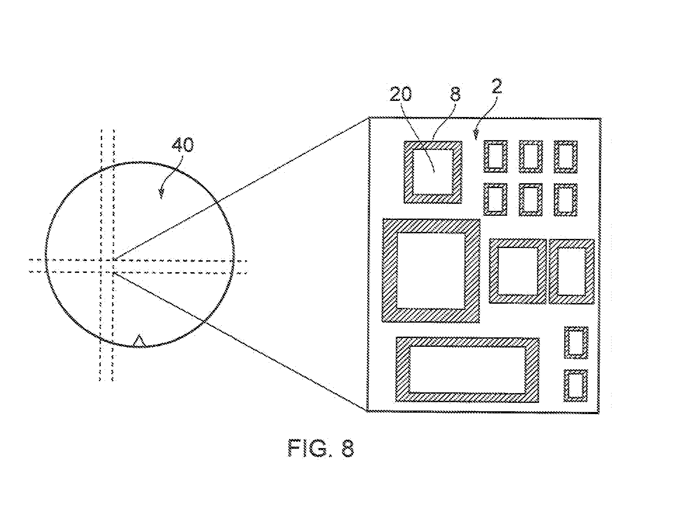

As illustrated in Figure 2, the trenches 8 define one or more device regions 20. The device regions are generally surrounded on each side by the trenches 8. The trenches may take on any suitable configuration to surround the device regions. For example, it is envisaged that the trenches may form quadrilateral island shaped device regions 20 (for example, square or rectangular device regions 20). However, other shapes for the device regions are envisaged, such as hexagonal. The shape of the trenches themselves, and their configuration when viewed from above the substrate will be described in more detail below in relation to Figure 8.

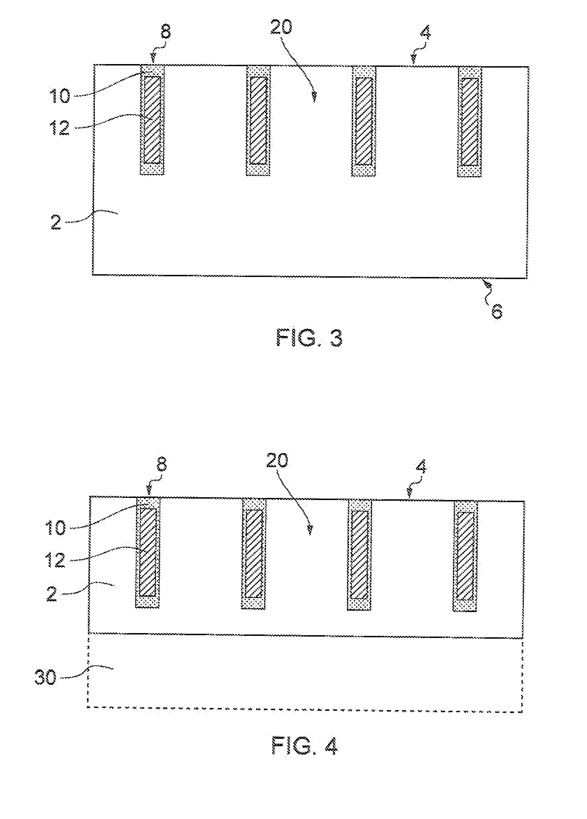

As shown in Figure 3, after the trenches 8 are formed in the initial layer 2, the trenches are filled. In one example, the trenches are filled with a dielectric material such as silicon oxide (of course, other kinds of dielectric may be used as appropriate).

In the example shown in Figure 3, the trenches are filled with a dielectric liner 10 and a polysilicon filling 12. As shown in Figure 3, the dielectric liner 10 substantially surrounds and encloses the polysilicon filling 12. It has been found that the use of a dielectric liner 10 for electrically isolating the active regions 20, in combination with a polysilicon filling 12, provides the resulting substrate with better protection against stress effects such as bowing and warping, than can be provided by using a trench which is completely filled with dielectric.

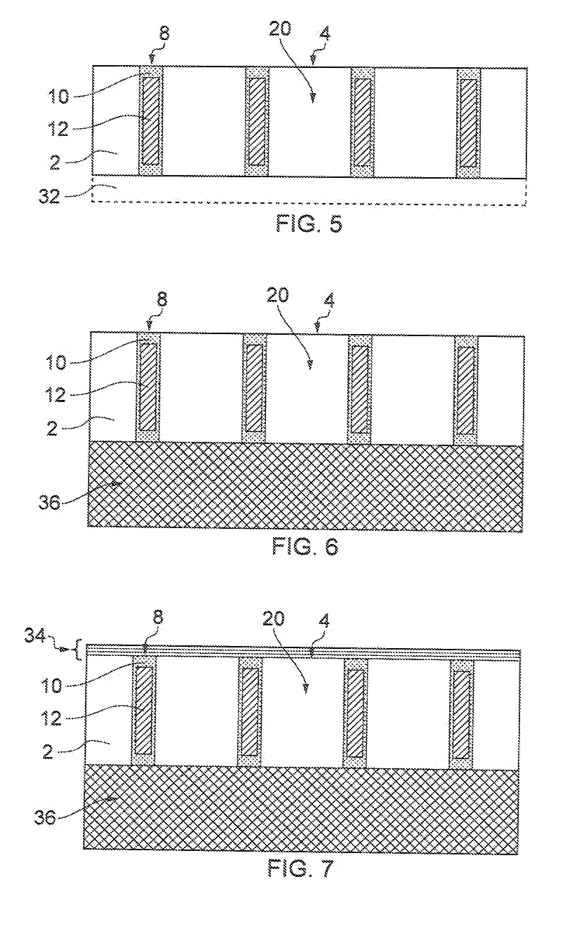

After the trenches 8 have been filled, a next stage in producing the substrate includes removing material from the underside 6 of the initial layer 2. This is illustrated in Figures 4 and 5. Typically, the material is removed from the underside 6 until the bottoms of the trenches 8 are exposed. However, as mentioned above, it is envisaged that the removal of the material from the underside 6 may continue after the bottoms of the trenches 8 have been exposed in accordance with design requirements. In any event, semiconducting material is removed from the underside 6 of the initial layer 2 at least until the trenches 8 extend fully through the remaining portion of the initial layer 2, whereby the device regions 20 between the trenches 8 are electrically isolated from each other by the trenches 8.

In accordance with an embodiment of the invention, material can be removed from the underside 6 of the initial layer 2 in a multi-stage process. For example, in a first stage (Figure 4), a course grinding process can be used to remove the bulk of the material from the underside 6. The dotted line indicates an example of the amount of the material 30 removed by a course grinding stage.

As shown in Figure 5, the course grinding stage can be followed by a fine grinding or polishing stage to remove the remaining material 32. Typically, it is the polishing stage at which the bottoms of the trenches 8 may be exposed.

Figure 6 shows a next stage of the process, in which a backing layer 36 is applied to the underside of the initial layer 2. The purpose of the backing layer 36 is to provide mechanical strength for the substrate, which is otherwise relatively weak due to the fact that it has been thinned, and contains trenches which extend fully there through.

Any suitable material may be used for the backing layer 36, however the material should be electrically insulating (to ensure the device regions remain electrically isolated). The material used for the backing layer 36 should also have good mechanical and thermal properties thereby to provide sufficient strength for the substrate while also providing a thermal path through the bottom of the substrate for heat dissipation away from the device regions 20. In one example, a polymer may be used for the backing layer 36. An example of such a polymer having good mechanical and thermal properties for the purposes of this application is polymide.

The backing layer 36 may be applied to the underside of the initial layer 2 using any suitable process. For example, a coating process such as spin-coating could be used.

The device regions 20 can be populated with electronic components such as transistors, diodes or capacitors. As shown in Figure 7, after the components have been formed in the device regions 20, one or more passivation and metallisation layers 34 can be provided on the major surface 4 to provide interconnections for the components in the device region 20.

Figure 8 illustrates examples of the device regions 20 described herein and the trenches 8 which surround them. As illustrated in the Figure 8, the initial layer of semiconductor material 2 may comprise or be part of a semiconductor wafer 40.

The shape of the device regions 20 and their sides may be chosen in accordance with the electronic component or components which they are designed to accommodate. In some examples, the device regions 20 may be adjacent, separated on at least one side by a shared trench 8. In other examples, and as shown in Figure 8, the device regions 20 and their respective trenches may be separate and removed from other device regions 20 and their respective other trenches 8 in the substrate.

Figure 8 shows that the device regions 20 and the trenches 8 which define them may typically be quadrilateral in shape (for example, square or rectangular). Nevertheless, it is envisaged that other shapes such as hexagonal device regions 20 could be used.

The sides of the device regions 20 can also be chosen in accordance with application requirements. In one example, there can be provided a high voltage component within a single respective device region 20, and such a device region can have an area of up to a few hundred square microns. However, it is envisaged that far larger device regions could be used, and that those device regions could accommodate large numbers of components.

Accordingly, there has been described a semiconductor substrate which includes layer of semiconductor material. The substrate also includes a series of trenches extending fully through the layer of semiconductor material to define a plurality of device regions therein. The trenches contain a dielectric material. The device regions are electrically isolated from each other by the trenches. A method of making the substrate includes providing an initial layer of semiconductor material. The method also includes forming a series of trenches extending partially through the initial layer to define a plurality of device regions therein. The method further includes providing dielectric material in trenches. The method also includes removing semiconductor material from an underside of the initial layer to leave a layer of semiconductor material through which the trenches fully extend, whereby the device regions are electrically isolated from each other by the trenches.

Although particular embodiments of the invention have been described, it will be appreciated that many modifications/additions and/or substitutions may be made within the scope of the claimed invention.

## Claims

1. A semiconductor substrate comprising:
a layer of semiconductor material; and
a series of trenches extending fully through the layer of semiconductor material to define a plurality of device regions in said layer, wherein the trenches contain a dielectric material, and wherein the device regions are electrically isolated from each other by said trenches.

2. The substrate of claim 1 further comprising electronic components located in said device regions.

3. The substrate of claim 2 comprising metallization and passivation layers on an upper surface of the layer of semiconductor material.

4. The substrate of any preceding claim comprising a backing layer on a lower surface of the layer of semiconductor material for strengthening the substrate.

5. The substrate of claim 4, wherein the backing layer comprises a polymer.

6. The substrate of claim 5, wherein the backing layer comprises polymide.

7. The substrate of any preceding claim, wherein the layer of semiconductor material has a thickness in the range 20 µm < T < 50 µm.

8. The substrate of any preceding claim, wherein the device regions comprise quadrilateral shaped islands.

9. The substrate of any preceding claim, wherein the trenches contain a dielectric liner filed with polysilicon.

10. A method of making a semiconductor substrate, the method comprising:
providing an initial layer of semiconductor material;
forming a series of trenches extending partially through the initial layer to define a plurality of device regions in the initial layer;
providing dielectric material in the trenches; and
removing semiconductor material from an underside of the initial layer to leave a layer of semiconductor material through which the trenches fully extend, whereby the device regions are electrically isolated from each other by said trenches.

11. The method of claim 10, wherein said removing semiconductor material from an underside of the initial layer comprises a coarse grinding stage followed by a fine grinding stage.

12. The method of claim 11, wherein said removing semiconductor material from an underside of the initial layer further comprises a polishing stage.

13. The method of any of claims 10 to 11 further comprising coating a lower surface of the layer of semiconductor material with a backing layer for strengthening the substrate.

14. The substrate of claim 13, wherein the backing layer comprises a polymer.

15. The substrate of claim 14, wherein the backing layer comprises polymide.
